# EUROPÄISCHE PATENTSCHRIFT

(11) **EP 2 294 613 B1**
(45) Veröffentlichungstag und Bekanntmachung des Hinweises auf die Patenterteilung: **02.08.2017**
(21) Anmeldenummer: 09772305.0
(22) Anmeldetag: 16.06.2009
(51) Int. Cl.: H01L 23/15, H01L 23/498

(54) **PLANARE ELEKTRISCHE LEISTUNGSELEKTRONIK-MODULE FÜR HOCHTEMPERATUR-ANWENDUNGEN UND ENTSPRECHENDE HERSTELLUNGSVERFAHREN**
PLANAR ELECTRICAL POWER ELECTRONIC MODULES FOR HIGH-TEMPERATURE APPLICATIONS, AND CORRESPONDING PRODUCTION METHODS
MODULES ÉLECTRIQUES PLANS D' ÉLECTRONIQUE DE PUISSANCE POUR DES APPLICATIONS SOUS HAUTE TEMPÉRATURE ET PROCÉDÉ DE FABRICATION CORRESPONDANT

(30) Priorität: 02.07.2008 DE 102008031231
(43) Veröffentlichungstag der Anmeldung: 16.03.2011
(73) Patentinhaber: Siemens Aktiengesellschaft, 80333 München (DE)
(72) Erfinder: LUPP, Friedrich, 81545 München (DE); WEIDNER, Karl, 81245 München (DE)
(86) Internationale Anmeldenummer: PCT/EP2009/057406
(87) Internationale Veröffentlichungsnummer: WO 2010/000605

(56) Entgegenhaltungen:
- EP-A- 0 607 656
- US-A- 5 896 271
- US-A1- 2007 235 810

## Beschreibung

Planare elektrische Leistungselektronik-Module für Hochtemperatur-Anwendungen und entsprechende Herstellungsverfahren Die vorliegende Erfindung betrifft ein Verfahren gemäß dem Oberbegriff des Hauptanspruchs und ein elektronisches Bauelement gemäß dem Oberbegriff des Nebenanspruchs. Ein verwandtes Verfahren und entsprechendes Bauelement sind beispielsweise in US 2007/235810 beschrieben.

Gemäß der planaren Verbindungstechnologie, insbesondere für die Technologie unter dem Siemens internen Begriff SiPLIT, wird die Isolierung der Kontaktleiterbahn durch den Auftrag einer Isolierfolie, die insbesondere ein Polymer aufweist, über die elektrischen Bauelemente auf Direct Copper Bond-Substraten (DCB-Substrat) geschaffen. Derartige herkömmliche Aufbau- und Verbindungstechnologien, wie dies beispielsweise SiPLIT, aber ebenso Bonden sind, ermöglichen vielfältige Varianten für thermisch bis 150° C beanspruchte Leistungselektronik-Anwendungen.

Besonders die herkömmliche Bondtechnologie ist der Maßstab hinsichtlich der Herstellungskosten von Leistungsbauelementen und Modulen. Des Weiteren gibt es eine Vielzahl von dem Bonden verwandten Ausführungen, wie es beispielsweise das Bändchenbonden und dergleichen ist. Bei der Herstellung von Leistungsmodulen werden im wesentlichen Direct Copper Bond-Substrate durch Auflöten von elektronischen Bauelementen bzw. Chips und/oder Surface Mounted Devices (SMDs) bestückt. Für die planare Verbindungstechnologie, insbesondere für die Technologie unter dem Siemens internen Begriff SiPLIT, wird die Isolierung und Strukturierung der Kontaktleiterbahnen über den Auftrag einer laserstrukturierten Isolierfolie bereitgestellt. Anschließend werden durch ein Strukturierungsprozess und elektrolytische Metallabscheidung, die der SiPLIT-Prozesstechnologie entspricht, die elektrische Verbindungen erzeugt.

Gemäß dem Stand der Technik ist die Dauertemperaturbelastbarkeit durch die Verwendung von polymeren Isolationsfolien auf < 175° C beschränkt.

Neben dem erreichen der technischen Anforderungen und Eigenschaften besteht ein Bedarf an Powermodulen bzw. Leistungsmodulen für Anwendungen > 200° C die neu, innovativ und insbesondere preiswert sind. Zunehmend gefordert sind Module für ein Temperatureinsatz > 200° C.

Die EP 0 607 656 A1 offenbart eine Vorrichtung mit einem Dünnschichtüberzug zur Verbindung von kleinen Bondflächen einer Halbleitereinrichtung zu einem Leiterrahmen oder einer flexiblen Schaltung sowie ein Verfahren zur Herstellung der Vorrichtung. Eine Feldpackungsvorrichtung mit hoher Kompaktheit in ländlichen Versorgungsnetzen kombiniert verschiedene elektronische Packungstechniken in einzigartiger Weise zur Erzeugung einer sehr dünnen, elektrischen und thermischen Packung für einzelne oder mehrfache Halbleitervorrichtungen mit hoher Leistungsfähigkeit. Ein dünnes und mechanisch stabiles Substrat oder Packungsmaterial mit ebenso hoher thermischer Leitfähigkeit wird ausgewählt. Ausnehmungen in dem Substrat oder Packungsmaterial nehmen eine oder mehrere Halbleitervorrichtungen auf, die direkt auf das Substrat oder Packungsmaterial angehängt sind. Ein Leiterrahmen oder eine flexible Schaltung ist auf einer Oberfläche des Substrats oder des Packungsmaterials angrenzend zu der Halbleitervorrichtung positioniert. Ein Dünnschichtüberzug mit einer Vielzahl von Schichten verbindet die eine oder mehreren Halbleitervorrichtungen zu Leitern auf einem Leiterrahmen oder einer flexiblen Schaltung.

Die US 5,896,271 offenbart ein flexibles Substrat mit einem thermischen Kontakt, der einen kontinuierlichen Hochwärmeleitfähigkeitspfad von einer Wärmeerzeugungskomponente zu einer Wärmesenke bereitstellt. Gemäß einer Ausführungsform umfasst der Thermokontakt eine metallische Spur einschließlich eines hervorgehobenen Merkmals thermisch leitenden Materials.

Eine Lötkugel kann zur Erzeugung einer Verbindung zwischen dem hervorgehobenen Merkmal und der Wärmeerzeugungskomponente oder zwischen dem hervorgehobenen Merkmal und der darunter liegenden Wärmesenke oder beiden verwendet werden.

Es ist Aufgabe der vorliegenden Erfindung elektronische Bauelemente, insbesondere Leistungsmodule, für einen Temperaturbereich insbesondere von größer 175°C bereitzustellen. Dabei sollen insbesondere elektrische Isolierungen wirksam elektrisch isolierend, wirksam haftend und thermomechanisch stabil sein. Es sollen insbesondere Hochtemperatur-Packages insbesondere für die Leistungselektronik geschaffen werden, die über die gesamte Lebensdauer thermomechanisch stabil sind.

Die Aufgabe wird durch ein Verfahren gemäß dem Hauptanspruch und eine Vorrichtung gemäß dem Nebenanspruch gelöst.

Zur Lösung wird insbesondere ein Modulaufbau ausschließlich unter Verwendung anorganischer Materialien vorgeschlagen, wie es beispielsweise Glas oder Keramik ist. Auf diese Weise werden Hochtemperatur-Packages, insbesondere für die Leistungselektronik, die der Hochtemperatur über die gesamte Lebensdauer ausgesetzt sind, durch Verwendung von anorganischen oder multigebundenen anorganischen Isoliermaterialien derart bereitgestellt, dass eine große elektrische Isolation, eine wirksame Haftung und eine stabile Thermomechanik geschaffen werden.

Es erfolgt ein Ausschneiden von Öffnungen in einer Trägerfolie, ein Positionieren und Fixieren von elektronischen Bauelementen, und beispielsweise Leadframes auf einer Trägerfolie. Des Weiteren erfolgt ein Herstellen von Kontaktierungen zwischen elektronischen Bauelementen und beispielsweise Leadframes und anderen Komponenten. Der erfindungsgemäße Aufbau kann bevorzugt zur produktiven Serienherstellung von Bauelementen bzw. Modulen in großen Stückzahlen bevorzugt für konventionelle Leistungsmodule verwendet werden. Durch die Verwendung von Hochtemperaturbeständigen, das heißt Temperaturbeständigkeit für Temperaturen > 175° C, wärmeleitfähigen, hochelektrisch isolierenden, strukturierten anorganischen Materialien können viele Vorteile bewirkt werden: Eine gute thermische Anbindung ebenso von Seitenflächen durch eine gute Formanpassungsfähigkeit, gutes thermisches Management und eine hohe elektrische Durchschlagsfestigkeit für Hochspannungsanwendungen. Weitere Vorteile sind eine verbesserte Zuverlässigkeit, eine reduzierte Verlustleistung, hohe Stromdichten, Integrationsfähigkeit, kompakter Aufbau, flexibles Layout, sowie elektromagnetische Abschirmung. Eine verbesserte Zuverlässigkeit bewirkt eine ausreichende Langzeitstabilität.

Die Öffnungen in der Trägerfolie können insbesondere durch Laserschneiden erzeugt werden.

Weitere vorteilhafte Ausgestaltungen werden in Verbindung mit den Unteransprüchen beansprucht.

Gemäß einer vorteilhaften Ausgestaltung erfolgt ein Füllen von Zwischenräumen mit einer mindestens ein zweites anorganisches Material aufweisenden Füllschicht zur elektrischen Isolierung. Die Isolierung von Zwischenräumen erfolgt über anorganische Materialien. Die Füllschicht weist eine Schichtdicke von 100 bis 400 Mikrometern auf. Es werden Zwischenräume insbesondere zwischen dem elektronischen Bauelement, der Trägerfolie und einem Leadframe befüllt. Ein dreidimensional geformter Leadframe ist eine elektrisch leitende, insbesondere metallische, dreidimensional geformte Struktur, beispielsweise in Form eines Gitters, das beispielsweise durch kostengünstiges Stanzen, Ätzen und/oder Biegen, beispielsweise auf einer Rolle oder in Streifen, hergestellt wird. Dreidimensional geformt bedeutet insbesondere aus einer Ebene herausgebogen. Als Materialien eignen sich vorzugsweise Cu-Legierungen, beispielsweise Zinnbronze CuSn6 oder SB02, das heißt, Cu98Fe2. Typische Dicken liegen im Bereich von 0,2 bis 0,5 mm. Im Unterschied zu den hier definierten dreidimensional geformten Leadframes werden ebenso ebene Leadframes verwendet. Der Sammelbegriff für dreidimensional geformte Leadframes und ebene Leadframes ist Leadframe. In den Ausführungsbeispielen ist ein dreidimensional geformter Leadframe als Stanzbiegeteil oder Stanzgitter verwendet.

Gemäß einer weiteren vorteilhaften Ausgestaltung ist das erste und/oder zweite anorganische Material ein keramisches Hochtemperatur-Material, das insbesondere durch Sprühen, Tauchen oder Sintern bereitgestellt wird, und zwar insbesondere in einer anorganischen Verbundmatrix.

Gemäß einer weiteren vorteilhaften Ausgestaltung ist das erste und/oder zweite anorganische Material Glas, das beispielsweise durch Umschmelzen von Glasloten bei einer Temperatur von 400° C erzeugt wird, Bornitrit, Borkarbid, Hochtemperaturzement, Siliziumnitrit, Mischkeramiken, Aluminiumoxid, multigebundenes Siliziumkarbid und/oder ein Keramikkleber, wie beispielsweise das Produkt "Ceramacoat" der Firma Kager. Es können SiC-Module bereitgestellt werden. Siliziumkarbid ist im Vergleich zur Si-Elektronik, insbesondere im Hinblick auf Schaltfrequenzen, Betriebstemperaturen und Leistungsdichte vorteilhaft. Das Material kann mittels Sputterprozesse, Chemical Vapor Deposition (CVD) oder Plasmaverfahren aufgebracht sein.

Gemäß einer weiteren vorteilhaften Ausgestaltung weist die Füllschicht einen Mehrschichtaufbau auf, wobei die einzelnen Schichten an unterschiedliche Anforderungen angepasst und mittels Aufspritzen oder Laminieren aufgebracht sind. Insbesondere Keramikschichten können die unterschiedlichen Anforderungen, das heißt beispielsweise Längenausdehnung, elektrische Isolierung oder Haftung durch einen Mehrschichtaufbau erfüllen. Beispielsweise ist die erste Lage dem Längenausdehnungskoeffizienten einer Bodenplatte angepasst, wie es beispielsweise ein Direct Copper Bond-Substrat, oder eine Kupfer-Bodenplatte ist. Ein Auftrag kann beispielsweise mittels Aufspritzen, und zwar Plasmaspritzen, Flammspritzen, Vakuum- und Niederdruckspritzen, oder ebenso mittels Laminieren der einzelnen Lagen erzeugt werden.

Gemäß einer weiteren vorteilhaften Ausgestaltung wird zwischen den einzelnen Schichten ein Haftvermittler, beispielsweise Silane, zur Bereitstellung einer wirksamen Haftung der Einzelschichten aufgebracht. Durch einen derartigen Haftvermittler wird zusätzlich eine gute Haftung zu den Einzelschichten bewirkt.

Gemäß einer weitern vorteilhaften Ausgestaltung wird auf der Füllschicht eine Lage, beispielsweise Al (OH₃), zum Schließen und Ausheilen der Poren und Risse der letzten Schicht, insbesondere mittels Siebdruckspritzen, Tauchen, Laminieren, Pinseln, aufgebracht. Zu dem ist die Dichtigkeit von großer Bedeutung. Dabei sind Siegler erzeugt. Auf diese Weise sind eine verbesserte Zuverlässigkeit, reduzierte Verlustleistungen, hohe Stromdichten, Integrationsfähigkeit, kompakter Aufbau, flexibles Layout, elektromagnetische Abschirmung durch die Stapelmöglichkeit, das heißt ein Sandwichaufbau, geschaffen.

Gemäß einer weiteren vorteilhafte Ausgestaltung erfolgt ein Erzeugen der elektrischen Kontaktierung mittels Aufbringens mindestens einer strukturierten, ebenen, elektrischen, insbesondere aus Cu-Ni/Au, Ag, Sn-Ag bestehenden Leiterschicht in der Öffnung und/oder auf mindestens einer Seite der elektrisch isolierenden Trägerfolie. Es wird eine geeignete, dünne, isolierende Trägerfolie aus anorganischen Material, wie es beispielsweise eine Glasfolie ist, beispielsweise mit beidseitiger strukturierter Cu-Metallisierung und insbesondere den Kontaktflächen, wie es beispielsweise Source-, Gate- und Drain-Kontakte sind, zugeordneten Öffnungen bereitgestellt. Bauelement Kontaktflächen sind entsprechend der Verbindungsverfahren beispielsweise in einem vorhergehenden Waferlevelprozess mit für die Verbindungsverfahren geeigneten funktionalen Schichten, beispielsweise Cu, Ni/Au, Ag, SnAg-Metallisierungen versehen.

Gemäß einer weiteren vorteilhaften Ausgestaltung erfolgt ein Erzeugen der Leiterschicht mittels Galvanisierens oder Ausdruckens. Bei einer Ankontaktierung durch Galvanik dient eine temporäre Fixiermittelfläche, beispielsweise eine Kleberfläche bzw. ein Kleberpodest ebenso als Abdichtung, das heißt es wird verhindert das Flüssigkeit zwischen die Trägerfolie und den elektronischen Bauelementen bzw. eventuellen Cu-Leadframes gelangt. Die Leiterbahnstrukturen bzw. Ankontaktierungen können ebenso durch einen Druckprozess nach erzeugter Vorpräparierung der elektronischen Bauelemente, nach Daten erzeugt werden.

Gemäß einer weiteren vorteilhaften Ausgestaltung erfolgt ein Erzeugen der elektrischen Kontaktierung mittels elektrischen Kontaktierens, beispielsweise mittels Lötens oder Schweißens, der Leiterschicht an mindestens ein Leadframe, der insbesondere aus Kupfer besteht. Als Ankontaktierung kann ein dem Layout angepasstes, insbesondere beidseitig aufgebrachtes Cu-Leadframe über Metallisierungen, beispielsweise galvanische Durchkontaktierungen, Lötverbindungen, Schweißverbindungen in beispielsweise Glasöffnungen bereitgestellt sein. Eine beidseitig mögliche, über Cu-Leadframes großflächige Bauelementkontaktierung kann beispielsweise über standardmäßige Lötverfahren oder ebenso mittels Lot freien Verbindungsverfahren erfolgen, wie dies beispielsweise Nano Ag, Laser-/Ultraschall-Schweißen und dergleichen sind. Außenanschlüsse können ebenso mittels der Gestaltung und Umformung von Leadframes, insbesondere Cu-Leadframes, kostengünstig mit erzeugt werden. Durch Verwendung der Leadframe-Verbindungstechnik und Anwendung automatisierter Prozesse können die elektronischen Bauelemente bzw. Leistungsmodule kostengünstig bereitgestellt werden.

Gemäß einer weiteren vorteilhaften Ausgestaltung erfolgt ein Positionieren des Bauelements mittels Automatisch Optischer Inspektion (AOI) auf einer temporären Fixiermittelfläche. Eine nach der AOI erfolgte Positionierung der elektronischen Bauelemente beispielsweise auf einer temporären Fixiermittelfläche ermöglicht die exakte Zuordnung zu den Kontaktflächen beispielsweise den Leadframes. Bei einer Ankontaktierung durch Galvanik dient diese Fixiermittelfläche ebenso als Abdichtung, das heißt es wird verhindert, dass Flüssigkeit zwischen der Trägerfolie und den Chips bzw. den Cu-Leadframes gelangt. Alternativ dazu können an kritischen Stellen auch ebenso dünne hydrophobe Schichten aufgebracht werden.

Gemäß einer weiteren vorteilhaften Ausgestaltung erfolgt ein Rückschleifen der Füllschicht bis auf die der Trägerfolie abgewandten Seite des Bauelements oder einer weiteren Komponente.

Gemäß einer weiteren vorteilhaften Ausgestaltung erfolgte ein Aufbringen von Kühlkörpern und/oder weiter Kontaktierungen auf der elektrischen Kontaktierung und/oder auf der der Trägerfolie abgewandten Seite des Bauelements. Daraus ergibt sich eine doppelseitige Kühlung, die eine verbesserte Zuverlässigkeit, reduzierte Verlustleistung, hohe Stromdichten, Integrationsfähigkeit, einen kompakten Aufbau, und ein flexibles Layout bewirkt. Es erfolgt ein Aufbringen von Kühlkörpern und/oder Rückseitenkontaktierungen. Vergleichbare Zusätze können ebenso bereitgestellt werden. Bei Bedarf kann die vorpräparierte Bauelemente Ober- und/oder Unterseite zur Verbesserung des thermischen Management zusätzlich beispielsweise mit dicken, strukturierten Cu-Blöcken für eine kurzzeitige Entwärmung im Kurzschlussfall ausgeführt sein.

Gemäß einer weiteren vorteilhaften Ausgestaltung können mittels Integration und Mehrschichtaufbauten der Bestandteile eingebettete Systeme, sogenannte embedded systems, bereitgestellt werden.

Die vorliegende Erfindung wird anhand von Ausführungsbeispielen in Verbindung mit den Figuren näher beschrieben. Es zeigen:
- Fig. 1: ein Ausführungsbeispiel eines erfindungsgemäßen Verfahrens;
- Fig. 2: ein Ausführungsbeispiel eines erfindungsgemäßen elektronischen Bauelements bzw. elektronischen Leistungsmoduls.

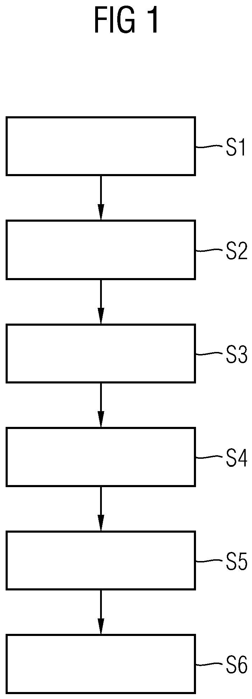

Figur 1 zeigt ein Ausführungsbeispiel eines erfindungsgemäßen Verfahrens, dabei weist das Verfahren folgende Schritte auf. Mit einem Schritt S1 erfolgt ein Ausschneiden der Öffnungen in einer Trägerfolie. Mit einem Schritt S2 erfolgt ein Positionieren und Fixieren der elektronischen Bauelemente, Leadframes und so weiter auf der Trägerfolie. Mit einem Schritt S3 erfolgt ein Befüllen der Zwischenräume. Mit einem Schritt S4 erfolgt ein Rückschleifen des Zwischenraummaterials bis auf die Rückseite des elektronischen Bauelements oder anderer Komponenten. Mit einem Schritt S5 erfolgt ein Herstellen der Kontaktierung zwischen elektronischen Bauelementen und Leadframes und anderer Komponenten. Mit einem Schritt S6 erfolgt ein Aufbringen von Kühlkörpern und/oder weiterer Rückseitenkontaktierungen.

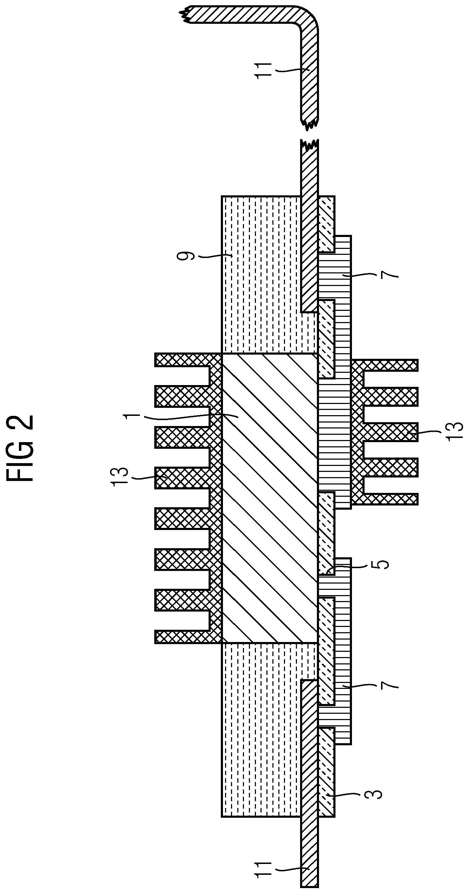

Gemäß einer weiteren Figur 2 wird ein Ausführungsbeispiel eines erfindungsgemäßen elektronischen Bauelements bzw. elektronischen Leistungsmoduls dargestellt. Bezugszeichen 1 bezeichnet ein elektronisches Bauelement, das beispielsweise ein Feldeffekttransistor ist. Andere elektronische Bauelemente sind ebenso möglich. Bezugszeichen 3 kennzeichnet eine mindestens ein erstes anorganische Material aufweisende, elektrisch isolierende Trägerfolie. Das Bauelement 1 ist auf der mindestens ein erstes anorganisches Material aufweisenden, elektrisch isolierenden Trägerfolie befestigt. Die Trägerfolie 3 weist mindestens eine Öffnung 5 auf, in der mindestens eine elektrische Kontaktierung 7 des Bauelements 1 nach außerhalb des Bauelements 1 vorgesehen ist. Außerhalb bedeutet ebenso aus einem Leistungsmodul heraus. Bezugszeichen 9 kennzeichnet eine mindestens ein zweites anorganisches Material aufweisende Füllschicht zur elektrischen Isolierung zum Füllen von Zwischenräumen. Dabei sind Zwischenräume beispielsweise, die Räume zwischen elektronischem Bauelement 1, Trägerfolie 3 und einem Leadframe 11. Dabei kann die Füllschicht 9 einen Mehrschichtaufbau aufweisen, wobei die einzelnen Schichten an unterschiedliche Anforderungen angepasst sind. Zwischen den einzelnen Schichten kann ein Haftvermittler zur Bereitstellung einer wirksamen Haftung der Einzelschichten ausgebildet sein. Auf der Füllschicht 9 kann eine Lage zum Schließen und Ausheilen der Poren und Risse der letzten Schicht aufgebracht sein. In Figur 2 ist die letzte Schicht die oberste Schicht der Füllschicht 9. Figur 2 zeigt das die elektrische Kontaktierung 7 mittels elektrischen Kontaktierens einer Leitschicht 7 an mindestens einen Leadframe 11 erzeugt ist, der insbesondere aus Kupfer besteht. Außenschlüsse sind durch die Gestaltung und Umformung des Leadframes 11 kostengünstig erzeugt. Bezugszeichen 13 kennzeichnet mindestens einen Kühlkörper und/oder weitere Kontaktierungen auf der elektrischen Kontaktierung 7 und/oder auf der der Trägerfolie 3 abgewandten Seite des Bauelements 1. Figur 2 zeigt ein Powermodul auf anorganischer Basis für Hochtemperaturanwendungen größer 175°C, insbesondere größer 200° C.

## Patentansprüche

1. Verfahren zur Erzeugung mindestens eines elektronischen Bauelements (1) eines Moduls mit den Schritten:
Ausschneiden mindestens einer für mindestens eine elektrische Kontaktierung (7) des Bauelements (1) vorgesehenen Öffnung (5) in einer mindestens ein erstes anorganisches Material aufweisenden elektrisch isolierenden Trägerfolie (3);
Positionieren und Fixieren des elektronischen Bauelements (1) auf der Trägerfolie (3);
Erzeugen der elektrischen Kontaktierung (7) nach außerhalb des elektronischen Bauelements (1), **dadurch gekennzeichnet, dass** zum Aufbau des Moduls ausschließlich anorganische oder multigebundene anorganische Isoliermaterialien (3; 9) verwendet werden, und weiter **gekennzeichnet durch** Füllen von Zwischenräumen zwischen elektronischem Bauelement (1), Trägerfolie (3) und einem Leadframe (11) mit einer mindestens ein zweites anorganisches Material aufweisenden Füllschicht (9) zur elektrischen Isolierung des elektronischen Bauelements (1) mittels eines Hochtemperatur-Packages.

2. Verfahren nach Anspruch 1,
**dadurch gekennzeichnet, dass**
das erste und/oder zweite anorganische Material ein keramisches Hochtemperatur-Material, insbesondere in einer anorganischen Verbundmatrix, ist.

3. Verfahren nach Anspruch 1 oder 2,
**dadurch gekennzeichnet, dass**
das erste und/oder zweite anorganische Material Glas, Bornitrit, Borkarbid, Hochtemperaturzement, Siliziumnitrit, Mischkeramik, Aluminiumoxid, Siliziumcarbid und/oder ein Keramikkleber ist.

4. Verfahren nach einem der vorhergehenden Ansprüche,
**dadurch gekennzeichnet, dass**
die Füllschicht (9) einen Mehrschichtaufbau aufweist, wobei die einzelnen Schichten an unterschiedliche Anforderungen angepasst und insbesondere mittels Aufspritzen oder Laminieren aufgebracht sind.

5. Verfahren nach Anspruch 4,
**dadurch gekennzeichnet, dass**
zwischen den einzelnen Schichten ein Haftvermittler, beispielsweise Silane, zur Bereitstellung einer wirksamen Haftung der Einzelschichten aufgebracht wird.

6. Verfahren nach einem der vorhergehenden Ansprüche,
**dadurch gekennzeichnet, dass**
auf der Füllschicht (9) eine Lage, beispielsweise Al(OH₃), zum Schließen und Ausheilen der Poren und Risse der letzten Schicht, insbesondere mittels Siebdruck, Spritzen, Tauchen, Laminieren, Pinseln, aufgebracht wird.

7. Verfahren nach einem der vorangehenden Ansprüche, **gekennzeichnet durch**
Erzeugen der elektrischen Kontaktierung (7) mittels Aufbringens mindestens einer strukturierten, ebenen, elektrischen, insbesondere aus Cu, Ni/Au, Ag, Sn-Ag bestehenden, Leiterschicht in der Öffnung (5) und/oder auf mindestens einer Seite der elektrisch isolierenden Trägerfolie (3).

8. Verfahren nach Anspruch 7,
**gekennzeichnet durch**
Erzeugen der Leiterschicht mittels Galvanisierens oder Aufdruckens.

9. Verfahren nach Anspruch 7 oder 8,
**gekennzeichnet durch**
Erzeugen der elektrischen Kontaktierung (7) mittels elektrischen Kontaktierens, beispielsweise mittels Lötens oder Schweißens, der Leiterschicht an mindestens einen Leadframe (11), der insbesondere aus Kupfer besteht.

10. Verfahren nach einem der vorhergehenden Ansprüche, **gekennzeichnet durch**
Positionieren des Bauelements (1) mittels automatischer optischer Inspektion auf einer
temporären Fixiermittelfläche.

11. Verfahren nach einem der vorhergehenden Ansprüche, **gekennzeichnet durch**
Rückschleifen der Füllschicht (9) bis auf die der Trägerfolie (3) abgewandten Seite des Bauelements (1) oder einer weiteren Komponente.

12. Verfahren nach einem der vorhergehenden Ansprüche, **gekennzeichnet durch**
Aufbringen mindestens eines Kühlkörpers (13) und/oder weiterer Kontaktierungen auf der elektrischen Kontaktierung und/oder auf der der Trägerfolie (3) abgewandten Seite des Bauelements (1).

13. Elektronisches Bauelement (1) eines Moduls, wobei das Bauelement (1) auf einer mindestens ein erstes anorganisches Material aufweisenden, elektrisch isolierenden Trägerfolie (3) befestigt ist, die mindestens eine Öffnung (5) aufweist, in der mindestens eine elektrische Kontaktierung (7) des Bauelements (1) nach außerhalb vorgesehen ist, **dadurch gekennzeichnet, dass** zum Aufbau des Moduls ausschließlich anorganische oder multigebundene anorganische Isoliermaterialien (3; 9) verwendet werden, und weiter **gekennzeichnet durch** eine mindestens ein zweites anorganisches Material aufweisende Füllschicht (9) zur elektrischen Isolierung des elektronischen Bauelements (1) mittels eines Hochtemperatur-Packages, wobei die Füllschicht (9) Zwischenräume zwischen elektronischem Bauelement (1), Trägerfolie (3) und einem Leadframe (11) füllt.

14. Elektronisches Bauelement nach Anspruch 13,
**dadurch gekennzeichnet, dass**
das erste und/oder zweite anorganische Material ein keramisches Hochtemperatur-Material, insbesondere in einer anorganischen Verbundmatrix, ist.

15. Elektronisches Bauelement nach Anspruch 13 oder 14,
**dadurch gekennzeichnet, dass**
das erste und/oder zweite anorganische Material Glas, Bornitrit, Borkarbid, Hochtemperaturzement, Siliziumnitrit, Mischkeramik, Aluminiumoxid, multigebundenes Siliziumcarbid und/oder ein Keramikkleber ist.

16. Elektronisches Bauelement nach einem der Ansprüche 13 bis 15, **dadurch gekennzeichnet, dass**
die Füllschicht (9) einen Mehrschichtaufbau aufweist, wobei die einzelnen Schichten an unterschiedliche Anforderungen angepasst sind.

17. Elektronisches Bauelement nach Anspruch 16,
**dadurch gekennzeichnet, dass**
zwischen den einzelnen Schichten ein Haftvermittler, beispielsweise Silane, zur Bereitstellung einer wirksamen Haftung der Einzelschichten ausgebildet ist.

18. Elektronisches Bauelement nach einem der Ansprüche 13 bis 17, **dadurch gekennzeichnet, dass**
auf der Füllschicht (9) eine Lage, beispielsweise aus Al (OH3), zum Schließen und Ausheilen der Poren und Risse der letzten Schicht aufgebracht ist.

19. Elektronisches Bauelement nach einem der vorangehenden Ansprüche 13 bis 18,
**dadurch gekennzeichnet, dass**
die elektrische Kontaktierung (7) mindestens eine strukturierte, ebene elektrische, insbesondere aus Cu, Ni/Au, Ag, Sn-Ag bestehende, Leiterschicht in der Öffnung und/oder auf mindestens einer Seite der elektrisch isolierenden Trägerfolie (3) aufweist.

20. Elektronisches Bauelement nach Anspruch 19,
**dadurch gekennzeichnet, dass**
die Leiterschicht mittels Galvanisierens oder Aufdruckens erzeugt ist.

21. Elektronisches Bauelement nach Anspruch 19 oder 20,
**dadurch gekennzeichnet, dass**
die elektrische Kontaktierung (7) mittels elektrischen Kontaktierens der Leiterschicht an mindestens einen Leadframe (11), der insbesondere aus Kupfer besteht, erfolgt.

22. Elektronisches Bauelement nach einem der Ansprüche 13 bis 21,
**dadurch gekennzeichnet, dass**
mindestens ein Kühlkörper (13) und/oder weiterer Kontaktierungen auf der elektrischen Kontaktierung (7) und/oder auf der der Trägerfolie (3) abgewandten Seite des Bauelements (1) aufgebracht ist.

## Claims

1. Method for creating at least one electronic component (1) of a module, with the following steps:
cutting out of at least one opening (5) intended for at least one electrical contact-connection (7) of the component (1) in an electrically-insulating carrier film (3) comprising at least one first inorganic material;
positioning and fixing the electrical component (1) on the carrier film (3);
creating the electrical contact-connection (7) to outside the electronic component (1),
**characterised in that**
exclusively inorganic or multi-bonded inorganic insulation materials (3; 9) are used for constructing the module,
and further **characterised by**
filling of spaces between electronic component (1), carrier film (3) and a leadframe (11) with a fill layer (9) comprising at least one second inorganic material for electrical insulation of the electronic component (1) by means of a high-temperature package.

2. Method according to claim 1,
**characterised in that**
the first and/or second inorganic material is a ceramic high-temperature material, especially in an inorganic composite matrix.

3. Method according to claim 1 or 2,
**characterised in that**
the first and/or second inorganic material is glass, boron nitride, boron carbide, high-temperature cement, silicon nitride, mixed ceramic, aluminium oxide, silicon carbide and/or a ceramic adhesive.

4. Method according to one of the preceding claims,
**characterised in that**
the fill layer (9) has a multilayer structure, with the individual layers being adapted to different requirements and especially being applied by means of spraying on or laminating.

5. Method according to claim 4,
**characterised in that**
an adhesion agent, for example Silane, is applied between the individual layers to provide effective adhesion between the individual layers.

6. Method according to one of the preceding claims,
**characterised in that**
a coating, for example Al (OH₃), is applied to the fill layer (9) for closing and healing the pores and tears of the last layer, especially by means of screen printing, spraying, dipping, lamination or painting.

7. Method according to one of the preceding claims,
**characterised by**
creation of the electrical contact-connection (7) by means of applying at least one structured, flat, electrical conductor layer especially consisting of Cu, Ni/Au, Ag, Sn-Ag in the opening (5) and/or to at least one side of the electrically-insulating carrier film (3).

8. Method according to claim 7,
**characterised by**
creating the conductor layer by means of electroplating or imprinting

9. Method according to claim 7 or 8,
**characterised by**
creating the electrical contact-connection (7) by means of electrical contacting, for example by means of soldiering or welding the conductor layer to at least one leadframe (11) which especially consists of copper.

10. Method according to one of the preceding claims,
**characterised by**
positioning the component (1) by means of automatic optical inspection on a temporary fixing means surface.

11. Method according to one of the preceding claims,
**characterised by**
looping back the fill layer (9) to the side of the component (1) or of a further component facing away from the carrier film (3).

12. Method according to one of the preceding claims,
**characterised by**
applying at least one heat sink (13) and/or further contact-connections to the electrical contact-connection and/or to the side of the component (1) facing away from the carrier film (3).

13. Electronic component (1) of a module, with the component (1) being attached to an electrically-insulating carrier film (3) comprising at least one inorganic material, which has at least one opening (5) in which at least one electrical contact-connection (7) of the component (1) to the outside is provided,
**characterised in that**
exclusively inorganic or multi-bonded inorganic insulation materials (3; 9) are used to construct the module,
and further **characterised by**
a fill layer (9) comprising at least one second inorganic material for electrical insulation of the electronic component (1) by means of a high-temperature package, with the fill layer (9) filling spaces between the electronic component (1), carrier film (3) and a leadframe (11).

14. Electronic component according to claim 13,
**characterised in that**
the first and/or second inorganic material is a ceramic high-temperature material, especially in an inorganic composite matrix.

15. Electronic component according to claim 13 or 14,
**characterised in that**
the first and or second inorganic material is glass, boron nitride, boron carbide, high-temperature cement, silicon nitride, mixed ceramic, aluminium oxide, silicon carbide and/or a ceramic adhesive.

16. Electronic component according to one of claims 13 to 15,
**characterised in that**
the fill layer (9) has a multilayer structure, with the individual layers being adapted to different requirements.

17. Electronic component according to claim 16,
**characterised in that**
an adhesion agent, for example Silane, is embodied between the individual layers to provide effective adhesion between the individual layers.

18. Electronic component according to one of claims 13 to 17,
**characterised in that** a layer, for example of Al (OH₃) is applied to the fill layer (9) for closing and healing the pores and tears of the last layer.

19. Electronic component according to one of the previous claims 13 to 18,
**characterised in that**
the electrical contact-connection (7) features at least one structured, flat, electrical conductor layer, especially consisting of Cu, Ni/Au, Ag, Sn-Ag in the opening and/or to at least one side of the electrically-insulating carrier film (3).

20. Electronic component according to claim 19,
**characterised in that**
the conductor layer is created by means of electroplating or printing.

21. Electronic component according to claim 19 or 20,
**characterised in that**
the electrical contact-connection (7) is effected by means of electrical contacting of the conductor layer to at least one leadframe (11) which especially consists of copper.

22. Electronic component according to one of claims 13 to 21,
**characterised in that**
at least one heat sink (13) and/or further contact-connections are applied to the electrical contact-connection (7) and/or to the side of the component (1) facing away from the carrier film (3).

## Revendications

1. Procédé de fabrication d'au moins un composant électronique (1) d'un module, comportant les étapes suivantes :
- découper au moins une ouverture (5) prévue pour au moins un contact électrique (7) du composant (1) dans une feuille de support (3) électriquement isolante qui comporte au moins une première matière inorganique ;
- positionner et fixer le composant électronique (1) sur la feuille de support (3) ;
- réaliser le contact électrique (7) vers l'extérieur du composant électronique (1),
**caractérisé en ce que** sont utilisées, pour la construction du module, des matières isolantes (3 ; 9) uniquement inorganiques ou inorganiques multicomposites, et **caractérisé en outre par** le remplissage d'interstices entre le composant électronique (1), la feuille de support (3) et une grille de connexion (11) avec une couche de remplissage (9) comportant au moins une deuxième matière inorganique pour isoler électriquement le composant électronique (1) au moyen d'un ensemble haute température.

2. Procédé selon la revendication 1, **caractérisé en ce que** la première et/ou la deuxième matière inorganique sont un matériau céramique haute température, en particulier dans une matrice composite inorganique.

3. Procédé selon la revendication 1 ou 2, **caractérisé en ce que** la première et/ou la deuxième matière inorganique sont du verre, du nitrure de bore, du carbure de bore, du ciment haute température, du nitrure de silicium, une céramique mixte, de l'oxyde d'aluminium, du carbure de silicium et/ou une colle céramique.

4. Procédé selon l'une des revendications précédentes, **caractérisé en ce que** la couche de remplissage (9) présente une structure multicouche, les différentes couches étant adaptées à différentes exigences et appliquées notamment par pulvérisation ou stratification.

5. Procédé selon la revendication 4, **caractérisé en ce qu'**est appliqué, entre les différentes couches, un promoteur d'adhérence, par exemple des silanes, pour obtenir une adhérence efficace des différentes couches.

6. Procédé selon l'une des revendications précédentes, **caractérisé en ce qu'**est appliquée, sur la couche de remplissage (9), une couche, par exemple d'Al(OH₃), pour fermer et réparer les pores et fissures de la dernière couche, en particulier par sérigraphie, projection, immersion, stratification, application au pinceau.

7. Procédé selon l'une des revendications précédentes, **caractérisé par** la réalisation d'un contact électrique (7) par application d'au moins une couche conductrice structurante, plane, électrique, en particulier en Cu, Ni/Au, Ag, Sn-Ag dans l'ouverture (5) et/ou sur au moins un coté de la feuille de support (3) électriquement isolante.

8. Procédé selon la revendication 7, **caractérisé par** la réalisation de la couche conductrice par galvanisation ou impression.

9. Procédé selon la revendication 7 ou 8, **caractérisé par** réalisation du contact électrique (7) par établissement d'un contact électrique, par exemple par brasage ou soudage, entre la couche conductrice et au moins une grille de connexion (11) plus particulièrement composée de cuivre.

10. Procédé selon l'une des revendications précédentes, **caractérisé par** le positionnement du composant (1) au moyen d'une inspection optique automatique sur une surface d'agent de fixation temporaire.

11. Procédé selon l'une des revendications précédentes, **caractérisé par** le meulage de la couche de remplissage (9) jusqu'au côté du composant (1), ou d'un autre composant, opposé à la feuille de support (3).

12. Procédé selon l'une des revendications précédentes, **caractérisé par** l'application d'au moins un corps de refroidissement (13) et/ou d'autres contacts sur le contact électrique et/ou sur le côté du composant (1) opposé à la feuille de support (3).

13. Composant électronique (1) d'un module, le composant (1) étant fixé sur au moins une feuille de support (3) électriquement isolante qui comporte une première matière inorganique, laquelle feuille comporte au moins une ouverture (5) dans laquelle est prévu au moins un contact électrique (7) entre le composant (1) et l'extérieur, **caractérisé en ce que** sont utilisées, pour la construction du module, des matières isolantes (3 ; 9) uniquement inorganiques ou inorganiques multicomposites, et **caractérisé en outre par** une couche de remplissage (9) comportant au moins une deuxième matière inorganique pour isoler électriquement le composant électronique (1) au moyen d'un ensemble haute température, la couche de remplissage (9) remplissant des interstices entre le composant électronique (1), la feuille de support (3) et une grille de connexion (11).

14. Composant électronique selon la revendication 13, **caractérisé en ce que** la première et/ou la deuxième matière inorganique sont un matériau céramique haute température, en particulier dans une matrice composite inorganique.

15. Composant électronique selon la revendication 13 ou 14, **caractérisé en ce que** la première et/ou la deuxième matière inorganique sont du verre, du nitrure de bore, du carbure de bore, du ciment haute température, du nitrure de silicium, une céramique mixte, de l'oxyde d'aluminium, du carbure de silicium multicomposite et/ou une colle céramique.

16. Composant électronique selon l'une des revendications 13 à 15, **caractérisé en ce que** la couche de remplissage (9) présente une structure multicouche, les différentes couches étant adaptées à différentes exigences.

17. Composant électronique selon la revendication 16, **caractérisé en ce qu'**est réalisé, entre les différentes couches, un promoteur d'adhérence, par exemple des silanes, pour obtenir une adhérence efficace des différentes couches.

18. Composant électronique selon l'une des revendications 13 à 17, **caractérisé en ce qu'**est appliquée, sur la couche de remplissage (9), une couche, par exemple d'Al(OH₃), pour fermer et réparer les pores et fissures de la dernière couche.

19. Composant électronique selon l'une des revendications précédentes 13 à 18, **caractérisé en ce que** le contact électrique (7) présente au moins une couche conductrice structurante, plane, électrique, en particulier en Cu, Ni/Au, Ag, Sn-Ag dans l'ouverture et/ou sur au moins un coté de la feuille de support (3) électriquement isolante.

20. Composant électronique selon la revendication 19, **caractérisé en ce que** la couche conductrice est réalisée par galvanisation ou impression.

21. Composant électronique selon la revendication 19 ou 20, **caractérisé en ce que** le contact électrique (7) est réalisé par établissement d'un contact électrique entre la couche conductrice et au moins une grille de connexion (11) plus particulièrement composée de cuivre.

22. Composant électronique selon l'une des revendications 13 à 21, **caractérisé en ce qu'**au moins un corps de refroidissement (13) et/ou d'autres contacts sont appliqués sur le contact électrique (7) et/ou sur le côté du composant (1) opposé à la feuille de support (3).
